# EUROPEAN PATENT SPECIFICATION

(11) **EP 4 322 305 B1**
(45) Date of publication and mention of the grant of the patent: **20.05.2026**
(21) Application number: 22911826.0
(22) Date of filing: 19.12.2022
(51) Int. Cl.: H01M 50/383, H01M 50/30, H01M 10/48, H01M 10/6563, H01M 10/613, H01M 10/6566, H01M 50/204, H01M 10/42, H01M 50/375

(54) **BATTERY SYSTEM, AND ENERGY STORAGE SYSTEM AND VEHICLE COMPRISING SAME**
BATTERIESYSTEM SOWIE ENERGIESPEICHERSYSTEM UND FAHRZEUG DAMIT
SYSTÈME DE BATTERIE, ET SYSTÈME DE STOCKAGE D'ÉNERGIE ET VÉHICULE LE COMPRENANT

(30) Priority: 21.12.2021 KR 20210184404; 24.12.2021 KR 20210187683
(43) Date of publication of application: 14.02.2024
(73) Proprietor: LG Energy Solution, Ltd., Seoul 07335 (KR)
(72) Inventor: OH, Young-Hoo, Daejeon 34122 (KR); KIM, Seung-Hyun, Daejeon 34122 (KR); OK, Seung-Min, Daejeon 34122 (KR); JO, Sang-Hyun, Daejeon 34122 (KR); CHO, Young-Bum, Daejeon 34122 (KR); HONG, Sung-Goen, Daejeon 34122 (KR)
(74) Representative: Plasseraud IP
(86) International application number: PCT/KR2022/020756
(87) International publication number: WO 2023/121193

(56) References cited:
- EP-A1- 2 797 158
- JP-A- 2013 175 296
- JP-A- 2015 037 019
- JP-A- 2015 095 361
- JP-A- H1 186 915
- KR-A- 20060 068 931
- KR-A- 20130 026 811
- US-A1- 2004 061 480
- US-A1- 2013 055 890

## Description

### TECHNICAL FIELD

The present disclosure relates to a battery system, and an energy storage system (ESS) and a vehicle including the same.

The present application claims priority to Korean Patent Application No. 10-2021-0184404 filed on December 21, 2021 and Korean Patent Application No. 10-2021-0187683 filed on December 24, 2021.

### BACKGROUND ART

A battery pack applied to a vehicle or an ESS may be manufactured in a form including a plurality of battery modules to which a secondary battery (e.g., lithium secondary battery) capable of realizing high output and high capacity is applied. In order to satisfy the output characteristics of the battery pack required by the device to which the battery pack is applied and to realize high capacity, the number of secondary batteries included in one battery module may be increased, and the number of battery modules included in one battery pack may be increased.

However, in the case of a battery pack including such a large number of secondary batteries, when a fire or explosion occurs, the damage is inevitably increased.

A fire occurring in a battery pack starts from an abnormal increase in temperature of a secondary battery disposed inside the battery module and generation of internal gas. When the temperature of the secondary battery rises abnormally and the internal pressure of the secondary battery rises above a certain level due to the generation of internal gas, venting occurs in the lithium secondary battery, whereby high-temperature gas may be emitted to the outside of the lithium secondary battery and high-temperature spark including an electrode active material, metal particles, and the like may be emitted.

In order to ensure safety in the use of the battery pack, the venting gas should be rapidly discharged to the outside of the battery pack so that the internal pressure of the battery pack no longer increases in the case of occurrence of an event. However, when the high-temperature spark together with the venting gas is discharged to the outside of the battery pack, the venting gas, the high-temperature spark, and oxygen may meet and cause a fire. In addition, when the venting gas and high-temperature spark discharged to the outside of the battery pack flow into an adjacent battery pack, a thermal event may spread and cause greater damage.

Therefore, when a thermal event occurs in some battery packs, it is required to develop a battery pack having a structure that may prevent fire-causing substances from spreading to adjacent battery packs and also suppress oxygen from flowing into the battery pack in which fire-causing substances exist.

EP 2 797 158, JP 2013 175296, US 2004/061480 and US 2013/055890 relate to temperature management system for battery.

### DISCLOSURE

### Technical Problem

The present invention is designed to solve the problems of the related art, and therefore the present invention is directed to preventing a thermal event from spreading to adjacent battery packs by controlling a discharge direction of a venting gas when a thermal event occurs in some battery packs in a battery system.

In another aspect, the present invention is directed to preventing oxygen from flowing into a battery pack having a problem when a thermal event occurs in some battery packs in a battery system.

In still another aspect, the present invention is directed to effectively blocking emission of a spark material to the outside of a battery pack when a thermal event occurs in some battery packs in a battery system.

However, technical problems to be solved by the present invention are not limited to the above-described problems, and other problems not mentioned herein may be clearly understood by those skilled in the art from the following description of the present invention.

### Technical Solution

The invention is defined in the set of claims. A battery system according to an embodiment of the present invention for solving the above-described problems includes a plurality of battery packs; a duct configured to communicate with the inside of each of the plurality of battery packs; and a cooling fan connected to the duct and configured to perform both the forward rotation and reverse rotation.

The forward rotation is a rotation in a direction in which cooling air is introduced into the plurality of battery packs through the duct, and the reverse rotation is a rotation in a direction in which air inside the plurality of battery packs is discharged through the duct.

The cooling fan is operated to perform the reverse rotation when a thermal event is detected in at least one of the plurality of battery packs.

The battery system includes a sensor configured to detect a thermal event when it occurs in at least one of the plurality of battery packs.

The sensor may be provided in each of the plurality of battery packs.

Each of the plurality of battery packs includes a first opening connected to the duct; and a second opening formed at a different location from the first opening.

The second opening is suitable to be opened when the cooling fan performs the forward rotation and closed when the cooling fan performs the reverse rotation.

The second openings provided in each of the plurality of battery packs may be operated to be opened and closed independently of each other.

The battery system may be configured such that when a thermal event occurs in at least one of the plurality of battery packs, the second opening provided in the battery pack where the thermal event occurs is closed, and the second opening provided in the other battery packs remains open.

The battery system may include a plurality of filters provided at each of the connection portions between the plurality of battery packs and the duct.

Each of the plurality of filters may be operated to be opened and closed.

Each of the plurality of filters may be configured to operate independently of each other.

The battery system may be configured such that when a thermal event occurs in at least one of the plurality of battery packs, a filter provided at a connection portion between the battery pack where the thermal event occurs and the duct among the plurality of filters performs a closing operation, and the other filters perform an opening operation.

Meanwhile, an ESS according to an embodiment of the present invention includes a battery system according to an embodiment of the present disclosure as described above.

A vehicle according to an embodiment of the present invention includes a battery system according to an embodiment of the present disclosure as described above.

### Advantageous Effects

According to one aspect of the present invention, it is possible to effectively prevent a thermal event from spreading to adjacent battery packs by controlling a discharge direction of a venting gas when a thermal event occurs in some battery packs in a battery system.

According to another aspect of the present invention, it is possible to effectively prevent oxygen from flowing into a battery pack having a problem when a thermal event occurs in some battery packs in a battery system.

According to still another aspect of the present invention, it is possible to effectively block emission of a spark material to the outside of a battery pack when a thermal event occurs in some battery packs in a battery system.

However, advantageous effects to be obtained by the present invention are not limited to the above-described effects, and other effects not mentioned herein may be clearly understood by those skilled in the art from the following description of the present invention.

### DESCRIPTION OF DRAWINGS

The accompanying drawings illustrate a preferred embodiment of the present invention and together with the foregoing invention, serve to provide further understanding of the technical features of the present invention, and thus, the present invention is not construed as being limited to the drawing.
FIG. 1 is a conceptual diagram illustrating a battery system according to an embodiment of the present invention.
FIGS. 2 and 3 are views illustrating air flow when a cooling fan rotates in a forward direction in the battery system shown in FIG. 1.
FIGS. 4 and 5 are views illustrating air flow when a cooling fan rotates in a reverse direction in the battery system shown in FIG. 1.
FIGS. 6 and 7 are views illustrating the sensor for detecting a thermal event in the battery system shown in FIG. 1.
FIG. 8 is a view illustrating the first opening and the second opening are provided in the battery pack of the present invention.
FIGS. 9 and 10 are views for describing the opening and closing of the second opening according to the forward and reverse rotation of a cooling fan.
FIG. 11 is a view illustrating an embodiment configured to independently perform an open/close operation of the second opening provided in each of a plurality of battery packs.
FIG. 12 is a view illustrating an embodiment in which a filter is provided at a connection portion between a battery pack and a duct in the battery system of the present invention.
FIGS. 13 and 14 are views illustrating installation positions of the filters shown in FIG. 12.
FIGS. 15 and 16 are views illustrating an embodiment configured to perform an open/close operation of the filter shown in FIG. 12.
FIGS. 17 and 18 are views for describing the opening and closing of the filter and the second opening in a normal state and a thermal event state.
FIG. 19 is a view illustrating an energy storage system (ESS) according to an embodiment of the present invention.
FIG. 20 is a view illustrating a vehicle according to an embodiment of the present invention.

### BEST MODE

Hereinafter, preferred embodiments of the invention will be described in detail with reference to the accompanying drawings.

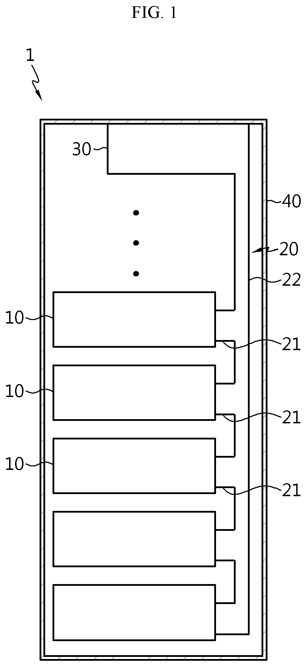

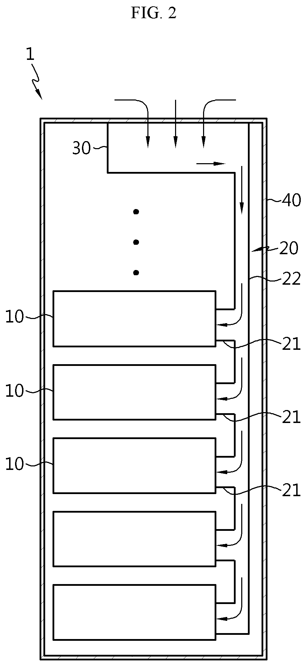

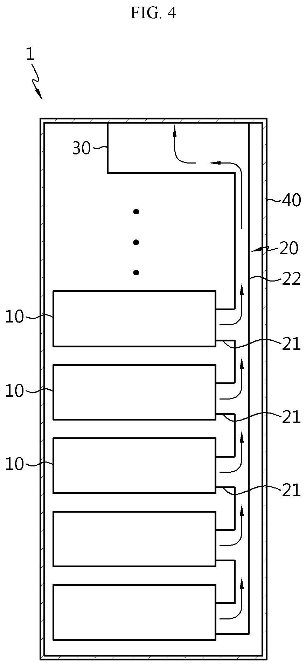

Referring to FIGS. 1 to 5, a battery system 1 according to an embodiment of the present invention includes a plurality of battery packs 10, a duct 20, and a cooling fan 30. The duct 20 is configured to communicate with the inside of each of the plurality of battery packs 10. The cooling fan 30 is connected to the duct 20 and is suitable to perform both the forward and reverse rotation.

In the battery system 1 having the above-described configuration, the circulation direction of air may be adjusted by controlling the rotation direction of the cooling fan 30. According to the configuration of the battery system 1, air may be smoothly supplied to the plurality of battery packs 10 when the battery system 1 is in a normal state. Meanwhile, according to the configuration of the battery system 1, when a thermal event occurs in the battery system 1, a fluid is induced to flow from the plurality of battery packs 10 toward the outside of the battery system 1, and thus it is possible to prevent a thermal event generated in some battery packs 10 from spreading to the other battery packs 10.

Meanwhile, the battery system 1 may include a battery housing 40 configured to accommodate the battery packs 10. The battery housing 40 may be configured to accommodate the duct 20 and/or the cooling fan 30 in addition to the battery packs 10. However, the present invention is not limited thereto, and a portion or all of the duct 20 and/or the cooling fan 30 may be exposed to the outside of the battery housing 40. The battery housing 40 may be, for example, a battery rack configured to load a plurality of battery packs 10 layer by layer. However, the present invention is not limited thereto, and the battery housing 40 may have different shapes depending on the use of the battery system 1 of the present invention, required capacity, output, and the like.

The forward rotation of the cooling fan 30 refers to a rotation in a direction in which cooling air is introduced into each of the plurality of battery packs 10 through the duct 20. On the other hand, the reverse rotation of the cooling fan 30 refers of to a rotation in a direction in which air inside the plurality of battery packs 10 is discharged through the duct 20. Accordingly, the cooling fan 30 is suitable to perform the forward rotation when the battery system 1 is in a normal state. The cooling fan 30 is suitable to perform the reverse rotation when a thermal event is detected in at least one of the plurality of battery packs 10.

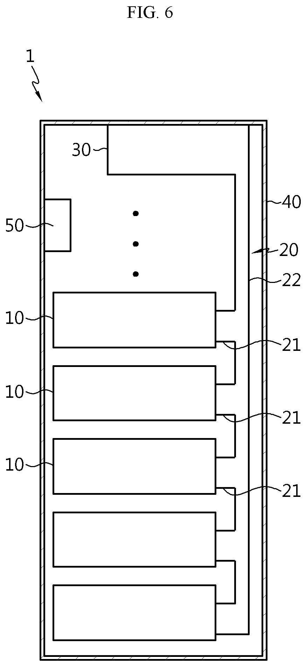

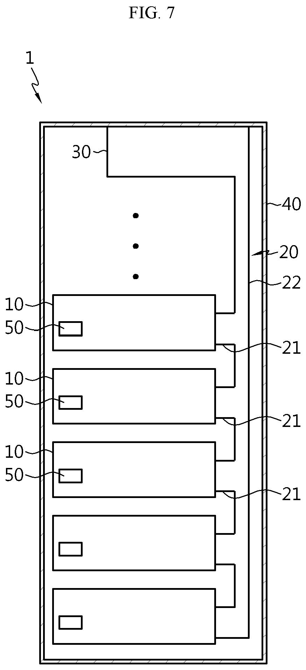

Meanwhile, the cooling fan 30 may be driven manually or automatically. For example, an operator or user may manually manipulate the rotation direction of the cooling fan 30 when a thermal event is detected. On the other hand, when a thermal event is detected through the sensor 50 (see FIGS. 6 and 7) to be described later, the rotation of the cooling fan 30 may be controlled according to a detection signal. According to the invention, the battery system 1 includes a control unit (not shown), and the control unit outputs a driving control signal of the cooling fan 30 according to a signal detected by the sensor 50, whereby the cooling fan 30 may be driven.

The battery system 1 may be configured such that a fluid circulates between the cooling fan 30 and the battery pack 10 only through the duct 20. For example, as shown in FIG. 1, the duct 20 may include a plurality of branch portions 21 configured to communicate with the inside of each battery pack 10 and a main stream portion 22 configured to connect the plurality of branch portions 21 and the cooling fan 30.

According to the battery system 1 of the present invention configured as described above, the cooling air supplied into the battery system 1 through the cooling fan 30 may be supplied to the plurality of battery packs 10, and thus efficient cooling may be achieved without installing cooling fans individually for each battery pack 10. According to another aspect of the battery system 1 of the present invention configured as described above, discharge pressure of a fluid may be formed in a direction from the plurality of battery packs 10 toward the cooling fan 30. Accordingly, it is possible to prevent a phenomenon in which the high-temperature venting gas and/or high-temperature spark materials generated by the thermal event of some battery packs 10 are introduced into the inside of the other battery packs 10 while moving within the duct 20. According to still another aspect of the battery system 1 of the present invention configured as described above, when a thermal event occurs in at least one of the plurality of battery packs 10, a fluid flow may be made to the outside of the battery system 1 so that oxygen is not introduced into the battery system 1 where the high-temperature venting gas and/or high-temperature spark material exist. Therefore, it is possible to prevent the high-temperature venting gas and/or high-temperature spark material from meeting with oxygen and satisfying the conditions for ignition. The spark material may include, for example, an electrode active material and/or metal fragments discharged by venting due to an increase in internal pressure of a battery cell.

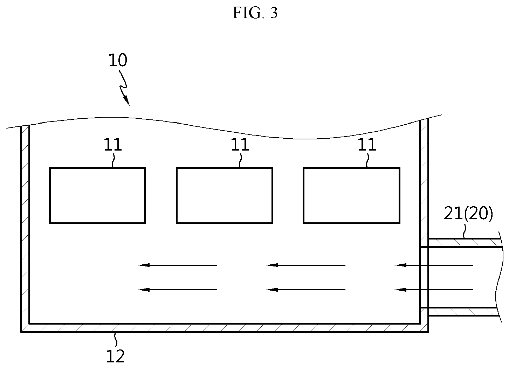

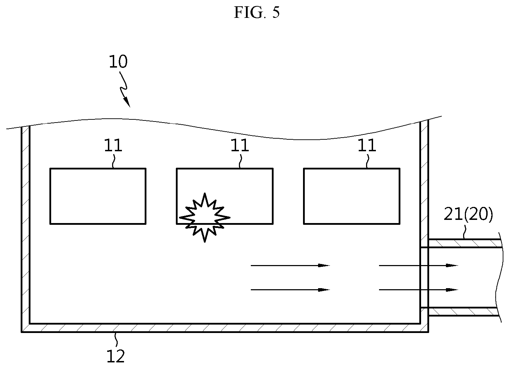

Meanwhile, referring to FIGS. 3 and 5, the battery pack 10 of the present invention may include a battery module 11 and a pack cover 12 configured to accommodate the battery module 11.

The battery module 11 may be provided in plurality. The battery module 11 may include a battery cell (not shown) and a module cover. The battery cell may be provided in plurality. However, the present disclosure is not limited thereto, and the module unit may be omitted and a plurality of battery cells may be directly accommodated in a pack cover. The pack cover 12 may have an opening. The duct 20 may communicate with the inner space of the pack cover 12 through the opening.

Next, referring to FIG. 6, the battery system 1 of the present invention includes a sensor 50. The sensor 50 is configured to detect a thermal event when it occurs in at least one of the plurality of battery packs 10. The sensor 50 may be configured to detect, for example, temperature and/or gas and/or smoke caused by fire.

Since the battery system 1 of the present invention includes the sensor 50 capable of detecting a thermal event, it is possible to rapidly detect the occurrence of a thermal event. Therefore, the rotation direction of the cooling fan 30 may be adjusted so that the cooling fan 30 performs the reverse rotation in response to the occurrence of a thermal event, thereby preventing the thermal event from spreading to the adjacent battery pack 10 and oxygen from flowing into the battery pack 10 where the thermal event has occurred.

Referring to FIG. 7, the sensor 50 may be provided in plurality. Each of the plurality of sensors 50 may be configured to independently detect a thermal event generated in each of the plurality of battery packs 10. For example, the number of sensors 50 may be at least equal to or greater than the number of battery packs 10. In this case, at least one sensor 50 may be provided for each battery pack 10.

As described above, when the battery system 1 of the present invention is configured to independently detect a thermal event generated in each of the plurality of battery packs 10, appropriate measures such as repair or replacement of the battery pack 10 where the thermal event occurs may be taken.

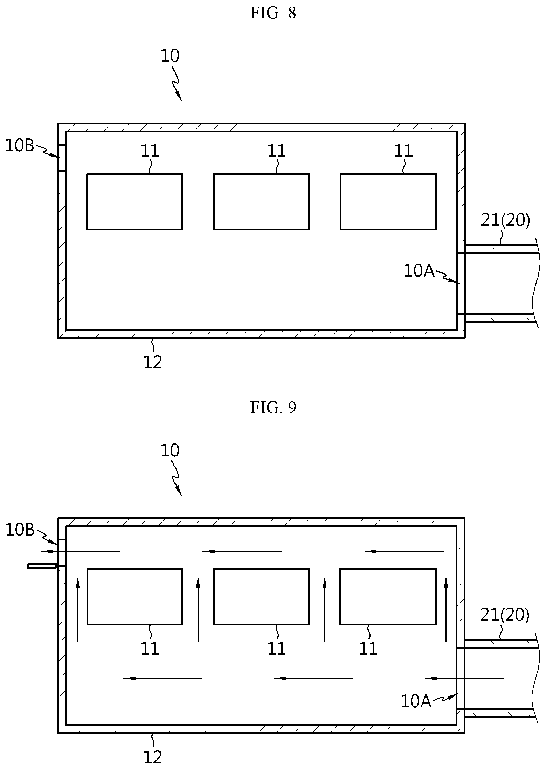

Next, referring to FIG. 8 together with FIG. 1, each of the plurality of battery packs 10 includes a first opening 10A and a second opening 10B. The first opening 10A is connected to the duct 20. The second opening 10B is formed at a different location from the first opening 10A.

Since the battery pack 10 has the second opening 10B in addition to the first opening 10A connected to the duct 20 as described above, the flow of fluid passing through the inside of the battery pack 10 may be smooth.

The first opening 10A and the second opening 10B may be, for example, openings formed by partially penetrating the pack cover 12. The second opening 10B may be formed on the opposite side of the region where the first opening 10A is formed.

For example, the first opening 10A may be provided at one end of the flow path formed between the plurality of battery modules 11 disposed in the pack cover 12 and one side of the pack cover 12 in the extension direction. The second opening 10B may be provided at the other end of the flow path formed between the plurality of battery modules 11 disposed in the pack cover 12 and the other side of the pack cover 12 in the extension direction. In this case, cooling air introduced through the first opening 10A may pass between adjacent battery modules 11 and be discharged to the outside of the battery pack 10 through the second opening 10B.

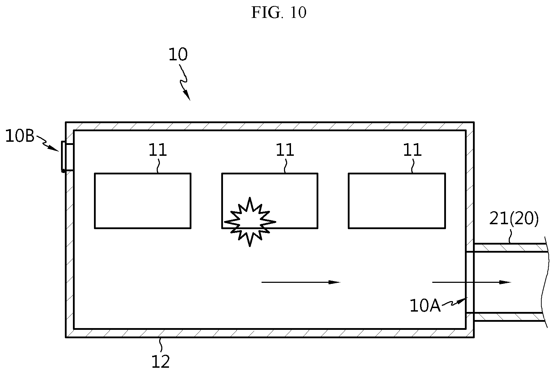

Next, referring to FIGS. 9 and 10 together with FIG. 1, the second opening 10B is suitable to be opened when the cooling fan 30 performs forward rotation and closed when the cooling fan 30 performs reverse rotation.

When the second opening 10B is operated in this way, it is possible not only to allow cooling air to be introduced more smoothly according to forward rotation of the cooling fan 30, but also to prevent oxygen from flowing into through the second opening 10B of the battery pack 10 where a thermal event occurs according to reverse rotation of the cooling fan 30.

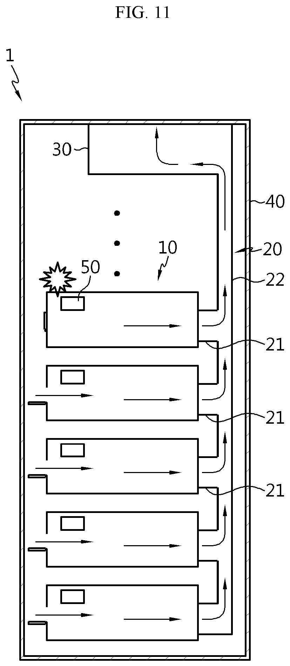

Next, referring to FIG. 11, the second openings 10B provided in each of the plurality of battery packs 10 may be configured to be opened and closed independently of each other. According to this configuration, by controlling the second opening 10B to be opened or closed depending on whether the battery pack 10 has a thermal event, it is possible to effectively prevent oxygen from flowing into the battery pack 10 where the thermal event occurs while maintaining the overall flow of air discharged to the outside of the battery system 1 smoothly.

For example, the battery system 1 may be configured such that when a thermal event occurs in at least one of the plurality of battery packs 10, the second opening 10B provided in the battery pack 10 where the thermal event occurs is closed, and the second opening 10B provided in the other battery packs 10 remains open. In this case, the second opening 10B of the battery pack 10 (the battery pack located at the top in FIG. 11) where the thermal event occurs may be closed to prevent oxygen from flowing into through the second opening 10B of the battery pack 10. On the other hand, the second openings 10B of the remaining battery packs 10 where no thermal event occurs remain open, and thus the air introduced through the second openings 10B may smoothly flow through the first opening 10A, the duct 20, and the cooling fan 30 sequentially. When sufficient air discharge pressure is formed to smoothly flow air in one direction in this way, a risk that venting gas and/or spark material discharged from the battery pack 10 where the thermal event occurs flows backward to the other battery pack 10 may be minimized.

Meanwhile, opening and closing of the second opening 10B is performed by a mean, for example, an opening/closing member installed in the second opening 10B. The operation of the opening/closing member may be performed manually or automatically. For example, when a thermal event is detected, the operator or user may manually close the second opening 10B of all the battery packs 10 or only the second opening 10B of the battery packs 10 where the thermal event is detected. On the other hand, when a thermal event is detected through the sensor 50 (see FIGS. 6 and 7), it is possible to control the opening and closing of the second opening 10B according to the detection signal. According to the invention, the battery system 1 includes a separate control unit (not shown), and the control unit is configured to output a control signal for opening or closing of the second opening 10B according to a signal detected by the sensor 50, whereby the second opening 10B may be opened or closed.

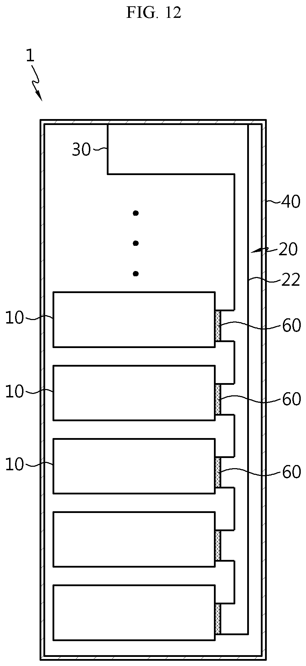

Next, referring to FIG. 12, the battery system 1 of the present invention may include a plurality of filters 60 provided at each of the connection portions between the plurality of battery packs 10 and the duct 20. When the venting gas and spark material generated in the battery pack 10 where the thermal event has occurred move toward the outside of the battery pack 10 by reverse rotation of the cooling fan 30, the filter 60 may be configured to allow the venting gas to pass and the spark material to be filtered out. The filter 60 may be, for example, a mesh-type filter.

When the battery system 1 of the present invention includes the filter 60 as described above, it is possible to reduce both the internal pressure of the battery pack 10 due to the discharge of venting gas and the risk of fire due to the prevention of discharge of spark material. Moreover, when the spark material is filtered by the filter 60, the filter 60 becomes clogged over time, thereby reducing the possibility of oxygen inflow due to the decrease of the discharge pressure of the venting gas, resulting in greatly reducing the risk of fire and/or explosion inside the battery pack 10.

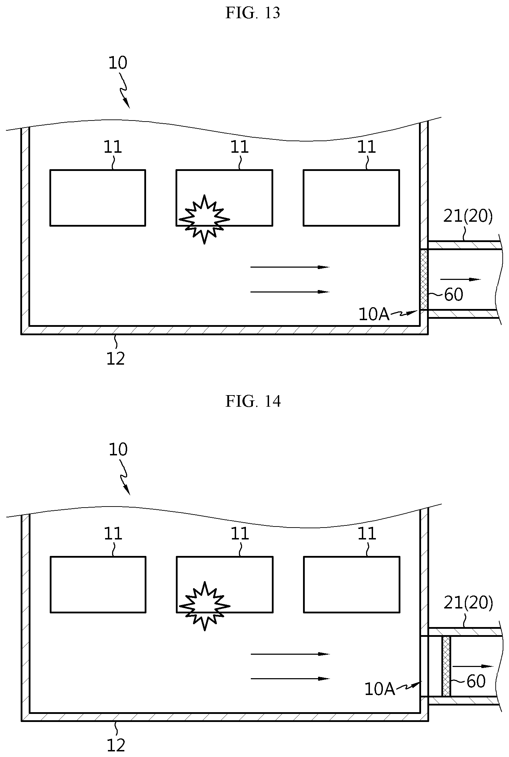

The filter 60 may be provided in the battery pack 10 as shown in FIG. 13. For example, the filter 60 may be configured to cover the first opening 10A formed in the pack cover 12 of the battery pack 10. Alternatively, the filter 60 may be provided in the duct 20 as shown in FIG. 14. The filter 60 may be provided, for example, in the branch portion 21 of the duct 20.

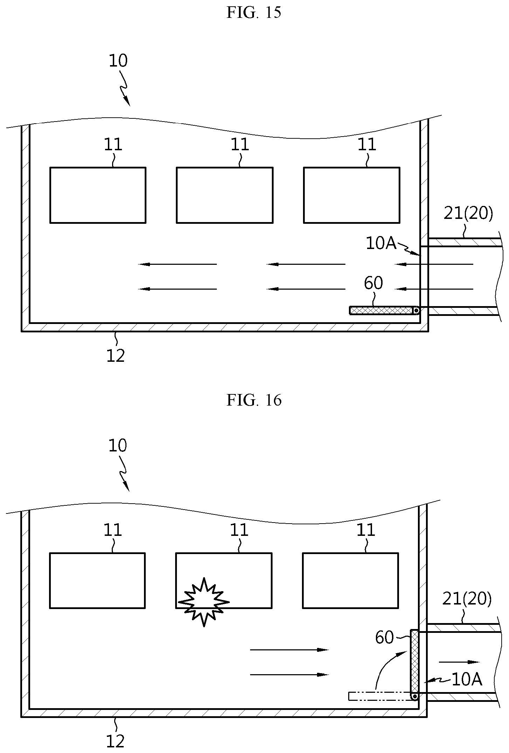

Next, referring to FIGS. 15 and 16, each of the plurality of filters 60 may be configured to be opened and closed. Each of the plurality of filters 60 may be configured to perform an opening operation during forward rotation of the cooling fan 30 (see FIG. 15) and a closing operation during reverse rotation of the cooling fan 30 (see FIG. 16). When the filter 60 performs an opening operation, the flow of cooling air into the battery pack 10 may be smoother. When the filter 60 performs a closing operation, the venting gas generated inside the battery pack 10 where the thermal event has occurred may be discharged to the outside through the duct 20, while the spark material may be filtered by the filter 60. Accordingly, it is possible to significantly reduce the risk of fire due to the blocking of discharge of the spark material while maintaining smooth reduction of internal pressure.

Meanwhile, each of the plurality of filters 60 provided at the connection portion between the plurality of battery packs 10 and the duct 20 may be configured to be independent of each other. For example, the battery system 1 may be configured such that when a thermal event occurs in at least one of the plurality of battery packs 10, the filter 60 provided at the connection portion between the battery pack 10 where the thermal event occurs and the duct 20 among the plurality of filters 60 performs a closing operation, and the other filters 60 perform an opening operation. When the battery system 1 is configured in this way, the spark material may be filtered only in the required region while maintaining a high discharge pressure of the fluid.

Meanwhile, the opening/closing operation of the filter 60 as described above may be controlled manually or automatically. For example, an operator or user may manually open the filter 60 when a thermal event is detected. On the other hand, when a thermal event is detected through the sensor 50 (see FIGS. 6 and 7), the closing operation of all filters 60 or the filter 60 installed at the connection portion between the battery pack 10 where the thermal event occurs and the duct 20 may be performed according to the detection signal. The control unit may output an operation control signal of the filter 60 according to a signal detected by the sensor 50, thereby operating the filter 60.

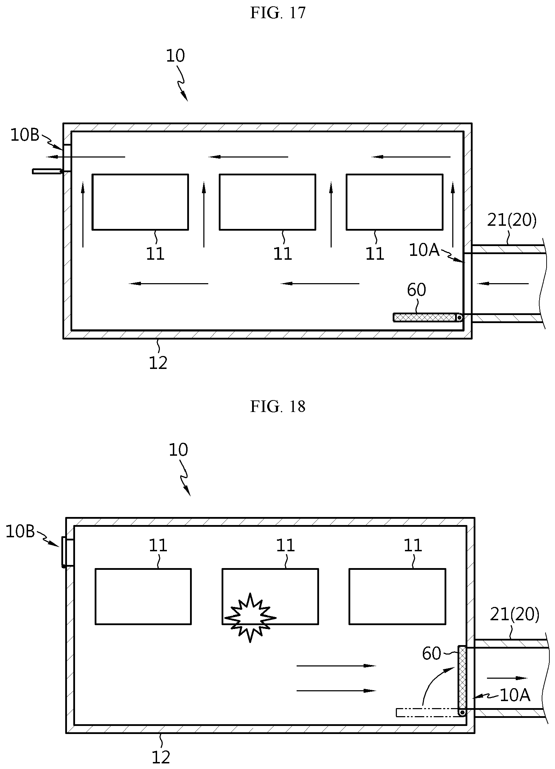

Next, referring to FIGS. 17 and 18, the filter 60 and the opening/closing member configured to open and close the second opening 10B may be configured to interlock with each other. For example, the opening/closing member and the filter 60 may perform the opening operation in the battery pack 10 where no thermal event is detected, and the opening/closing member and the filter 60 may perform the closing operation in the battery pack 10 where the thermal event is detected.

When both the filter 60 and the opening/closing member are in an open state during air inflow due to forward rotation of the cooling fan 30 (see FIG. 12), the flow of air passing through the battery pack 10 is smooth, and thus cooling efficiency may be improved. When both the filter 60 and the opening/closing member are in a closed state during air discharge due to reverse rotation of the cooling fan 30 (see FIG. 12), it is possible to prevent oxygen from flowing into the battery pack 10, to allow venting gas to be discharged to the outside smoothly, and to block the discharge of spark material.

Meanwhile, as described above, the operation of the cooling fan 30, the filter 60, and the opening/closing member configured to open and close the second opening 10B may be performed manually or automatically. According to the invention, the battery system 1 includes a control unit (not shown), and the control unit may output a control signal for controlling the operation of the cooling fan 30, the filter 60, and the opening/closing member of the second opening 10B according to a signal detected by the sensor 50, thereby interlocking the operation of each component.

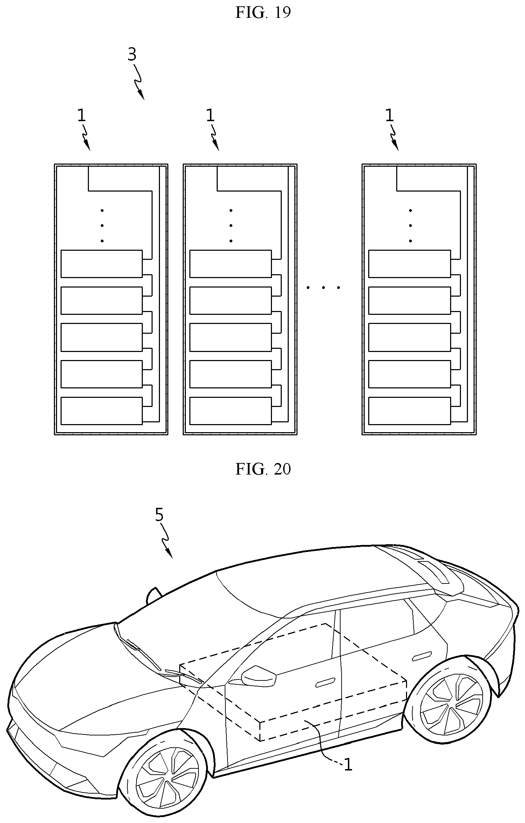

Referring to FIG. 19, an energy storage system (ESS) 3 according to an embodiment of the present invention may include a battery system 1 according to the present invention. The ESS 3 may include, for example, a plurality of battery systems 1. Referring to FIG. 20, a vehicle 5 according to an embodiment of the present invention may include a battery system 1 according to the present invention. The vehicle 5 may include, for example, a plurality of battery systems 1. The vehicle 5 may be configured to operate by receiving power from the battery system 1. The vehicle 5 may be, for example, an electric vehicle (EV) or a hybrid electric vehicle (HEV).

### [Reference Signs]

1: battery system
3: energy storage system (ESS)
5: vehicle
10: battery pack
10A: first opening
10B: second opening
11: battery module
12: pack cover
20: duct
21: branch portion
22: main stream portion
30: cooling fan
40: battery housing
50: sensor
60: filter

## Claims

1. A battery system (1) comprising:
- a plurality of battery packs (10),
- a duct (20) communicating with the inside of each of the plurality of battery packs,
- a cooling fan (30) connected to the duct (20),
- a sensor (50) configured to detect a thermal event when it occurs in at least one of the plurality of battery packs (10), and
- a control unit configured for operating the cooling fan (30) to perform a forward rotation in a direction in which cooling air is introduced into the plurality of battery packs through the duct (20), and a reverse rotation in a direction in which air inside the plurality of battery packs is discharged through the duct (20) when a thermal event is detected in at least one of the plurality of battery packs (10),
wherein each of the plurality of battery packs comprises:
- a first opening (10A) connected to the duct; and
- a second opening (10B) formed at a different location from the first opening, and
- a mean for opening and closing the second opening (10B),
wherein the second opening is suitable to be opened when the cooling fan performs the forward rotation and closed when the cooling fan performs the reverse rotation.

2. The battery system according to claim 1,
wherein a sensor (50) is provided in each of the plurality of battery packs.

3. The battery system according to claim 1,
wherein the second openings (10B) provided in each of the plurality of battery packs (10) are operated to be opened and closed independently of each other.

4. The battery system according to claim 3, wherein the second opening (10B) provided in a battery pack (10) where a thermal event occurs is operated to be closed, and the second opening (10B) provided in the other battery packs are operated to remain open.

5. The battery system according to claim 1, which comprises a plurality of filters (60) provided at each of the connection portions between the plurality of battery packs (10) and the duct (20).

6. The battery system according to claim 5, comprising a mean for opening and closing each of the plurality of filters.

7. The battery system according to claim 6, wherein each of the plurality of filters (60) is configured to operate independently of each other.

8. The battery system according to claim 7, wherein a filter (60) provided at a connection portion between the battery pack (10) where a thermal event occurs and the duct (20), among the plurality of filters (60), is operated to perform a closing operation, and the other filters are operated to perform an opening operation.

9. An energy storage system comprising a battery system according to any one of claims 1 to 8.

10. A vehicle comprising a battery system according to any one of claims 1 to 8.

11. A method for preventing spreading of a thermal event in a battery system, wherein the battery system is according to any one of claims 1 to 8, and wherein the method comprises a step of performing the reverse rotation of the cooling fan (30) when a thermal event is detected in at least one of the plurality of battery packs (10).

12. The method according to claim 11, wherein the battery system is according to any one of claims 3 to 8 and the method comprises a step of opening the second opening (10B) when the cooling fan (30) performs the forward rotation and closing the second opening (10B) when the cooling fan (30) performs the reverse rotation.

## Patentansprüche

1. Batteriesystem (1), umfassend:
- eine Mehrzahl von Batteriepacks (10),
- einen Kanal (20), welcher mit dem Inneren jedes der Mehrzahl von Batteriepacks in Verbindung steht,
- ein Kühlgebläse (30), welches mit dem Kanal (20) verbunden ist,
- einen Sensor (50), welcher dazu eingerichtet ist, ein thermisches Ereignis zu detektieren, wenn es in wenigstens einem der Mehrzahl von Batteriepacks (10) auftritt, und
- eine Steuereinheit, welche dazu eingerichtet ist, das Kühlgebläse (30) zu betreiben, um eine Vorwärtsdrehung in einer Richtung, in welcher Kühlluft durch den Kanal (20) in die Mehrzahl von Batteriepacks eingeführt wird, und eine Rückwärtsdrehung in einer Richtung durchzuführen, in welcher Luft innerhalb der Mehrzahl von Batteriepacks durch den Kanal (20) abgeführt wird, wenn ein thermisches Ereignis in wenigstens einem der Mehrzahl von Batteriepacks (10) detektiert wird,
wobei jeder der Mehrzahl von Batteriepacks umfasst:
- eine erste Öffnung (10A), welche mit dem Kanal verbunden ist; und
- eine zweite Öffnung (10B), welche an einer von der ersten Öffnung verschiedenen Stelle gebildet ist, und
- ein Mittel zum Öffnen und Schließen der zweiten Öffnung (10B),
wobei die zweite Öffnung dazu geeignet ist, geöffnet zu sein, wenn das Kühlgebläse die Vorwärtsdrehung durchführt, und geschlossen zu sein, wenn das Kühlgebläse die Rückwärtsdrehung durchführt.

2. Batteriesystem nach Anspruch 1,
wobei ein Sensor (50) in jedem der Mehrzahl von Batteriepacks (10) bereitgestellt ist.

3. Batteriesystem nach Anspruch 1,
wobei die zweiten Öffnungen (10B), welche in jedem der Mehrzahl von Batteriepacks (10) bereitgestellt sind, derart betrieben werden, dass sie unabhängig voneinander geöffnet und geschlossen sind.

4. Batteriesystem nach Anspruch 3, wobei die zweite Öffnung (10B), welche in einem Batteriepack (10) bereitgestellt ist, an welchem ein thermisches Ereignis auftritt, derart betrieben wird, dass sie geschlossen ist, und die zweite Öffnung (10B), welche in den anderen Batteriepacks bereitgestellt ist, derart betrieben werden, dass sie offen bleiben.

5. Batteriesystem nach Anspruch 1, welches eine Mehrzahl von Filtern (60) umfasst, welche an jedem der Verbindungsabschnitte zwischen der Mehrzahl von Batteriepacks (10) und dem Kanal (20) bereitgestellt sind.

6. Batteriesystem nach Anspruch 5, umfassend ein Mittel zum Öffnen und Schließen jedes der Mehrzahl von Filtern.

7. Batteriesystem nach Anspruch 6, wobei jeder der Mehrzahl von Filtern (60) dazu eingerichtet ist, unabhängig voneinander zu arbeiten

8. Batteriesystem nach Anspruch 7, wobei ein Filter (60), welcher an einem Verbindungsabschnitt zwischen dem Batteriepack (10), an welchem ein thermisches Ereignis auftritt, und dem Kanal (20) bereitgestellt ist, unter der Mehrzahl von Filtern (60) derart betrieben wird, dass er einen Schließvorgang durchführt, und die anderen Filter derart betrieben werden, dass sie einen Öffnungsvorgang durchführen.

9. Energiespeichersystem, umfassend ein Batteriesystem nach einem der Ansprüche 1 bis 8.

10. Fahrzeug, umfassend ein Batteriesystem nach einem der Ansprüche 1 bis 8.

11. Verfahren zum Verhindern eines Ausbreitens eines thermischen Ereignisses in einem Batteriesystem, wobei das Batteriesystem einem der Ansprüche 1 bis 8 entspricht und wobei das Verfahren einen Schritt eines Durchführens der Rückwärtsdrehung des Kühlgebläses (30) umfasst, wenn ein thermisches Ereignis in wenigstens einem der Mehrzahl von Batteriepacks (10) detektiert wird.

12. Verfahren nach Anspruch 11, wobei das Batteriesystem einem der Ansprüche 3 bis 8 entspricht und das Verfahren einen Schritt eines Öffnens der zweiten Öffnung (10B), wenn das Kühlgebläse (30) die Vorwärtsdrehung durchführt, und eines Schließens der zweiten Öffnung (10B) umfasst, wenn das Kühlgebläse (30) die Rückwärtsdrehung durchführt.

## Revendications

1. Système de batterie (1) comprenant :
- une pluralité de blocs-batteries (10),
- un conduit (20) communiquant avec l'intérieur de chacun de la pluralité de blocs-batteries,
- un ventilateur de refroidissement (30) raccordé au conduit (20),
- un capteur (50) configuré pour détecter un événement thermique lorsqu'il se produit dans au moins un parmi la pluralité de blocs-batteries (10), et
- une unité de commande configurée pour la mise en opération du ventilateur de refroidissement (30) pour qu'il réalise une rotation en marche avant dans une direction dans laquelle de l'air de refroidissement est introduit dans la pluralité de blocs-batteries par le conduit (20), et une rotation en marche arrière dans une direction dans laquelle de l'air à l'intérieur de la pluralité de blocs-batteries est évacué par le conduit (20) lorsqu'un événement thermique est détecté dans au moins un parmi la pluralité de blocs-batteries (10),
dans lequel chacun de la pluralité de blocs-batteries comprend :
- une première ouverture (10A) raccordée au conduit ; et
- une seconde ouverture (10B) formée à un emplacement différent de la première ouverture, et
- un moyen pour l'ouverture et la fermeture de la seconde ouverture (10B), dans lequel la seconde ouverture est appropriée pour être ouverte lorsque le ventilateur de refroidissement réalise la rotation en marche avant et fermée lorsque le ventilateur de refroidissement réalise la rotation en marche arrière.

2. Système de batterie selon la revendication 1,
dans lequel un capteur (50) est ménagé dans chacun de la pluralité de blocs-batteries.

3. Système de batterie selon la revendication 1,
dans lequel les secondes ouvertures (10B) ménagées dans chacun de la pluralité de blocs-batteries (10) sont mises en opération pour être ouvertes et fermées indépendamment les unes des autres.

4. Système de batterie selon la revendication 3, dans lequel la seconde ouverture (10B) ménagée dans un bloc-batterie (10) où un événement thermique se produit est mise en opération pour être fermée, et les secondes ouvertures (10B) ménagées dans les autres blocs-batteries sont mises en opération pour rester ouvertes.

5. Système de batterie selon la revendication 1, qui comprend une pluralité de filtres (60) ménagés au niveau de chacune des parties de raccordement entre la pluralité de blocs-batteries (10) et le conduit (20).

6. Système de batterie selon la revendication 5, comprenant un moyen pour l'ouverture et la fermeture de chacun de la pluralité de filtres.

7. Système de batterie selon la revendication 6, dans lequel chacun de la pluralité de filtres (60) est configuré pour effectuer des opérations indépendamment des autres.

8. Système de batterie selon la revendication 7, dans lequel un filtre (60) ménagé au niveau d'une partie de raccordement entre le bloc-batterie (10) où un événement thermique se produit et le conduit (20), parmi la pluralité de filtres (60), est mis en opération pour réaliser une opération de fermeture, et les autres filtres sont mis en opération pour réaliser une opération d'ouverture.

9. Système de stockage d'énergie, comprenant un système de batterie selon l'une quelconque des revendications 1 à 8.

10. Véhicule comprenant un système de batterie selon l'une quelconque des revendications 1 à 8.

11. Procédé pour empêcher la propagation d'un événement thermique dans un système de batterie, dans lequel le système de batterie est selon l'une quelconque des revendications 1 à 8, et dans lequel le procédé comprend une étape de réalisation de la rotation en marche arrière du ventilateur de refroidissement (30) lorsqu'un événement thermique est détecté dans au moins un parmi la pluralité de blocs-batteries (10).

12. Procédé selon la revendication 11, dans lequel le système de batterie est selon l'une quelconque des revendications 3 à 8 et le procédé comprend une étape d'ouverture de la seconde ouverture (10B) lorsque le ventilateur de refroidissement (30) réalise la rotation en marche avant et de fermeture de la seconde ouverture (10B) lorsque le ventilateur de refroidissement (30) réalise la rotation en marche arrière.
